# EUROPEAN PATENT APPLICATION

(11) **EP 1 332 800 A1**
(43) Date of publication of application: **06.08.2003**
(21) Application number: 00966482.2
(22) Date of filing: 13.10.2000
(51) Int. Cl.: B05B 13/02, B05B 15/12, H05K 3/28, B05D 1/02

(54) **COATING DEVICE FOR ELECTRIC OR ELECTRONIC CIRCUIT BOARDS, COATING METHOD USING THIS DEVICE, AND ELECTRIC OR ELECTRONIC CIRCUIT BOARD COATED BY THIS METHOD**

(71) Applicant: Kem-Tec Japan Co., Ltd, Utsunomiya-shi, Tochigi 321-0137 (JP)
(72) Inventor: YANAGIDA, Kazuyo, Toda-shi, Saitama 335-0013 (JP)
(74) Representative: Riebling, Peter, Dr.-Ing.
(86) International application number: JP0007132
(87) International publication number: WO02032587

(57) **Abstract**

ABSTRACT

A plate-like workpiece to be coated (100) is suspended, positioned and conveyed between a pair of nozzle units (4,4) arranged opposing each other in an application space 3 inside an application booth (2). A coating agent (A) is sprayed from a plurality of spray nozzles (5) arranged on each nozzle unit (4) in a row at regular intervals so as to coat both the front and rear application surfaces (100a) and (100b) of the plate-like workpiece to be coated (100) while the plate-like workpiece to be coated (100) is being moved in a direction (X) perpendicular to the direction in which individual spray nozzles 5 are arrayed. With this arrangement it is possible to provide a coating machine for electric or electronic circuit boards, which has a simple mechanism and configuration and is reduced in size and installation space with improved productivity and economy, as well as providing a coating method using the machine and an electric or electronic circuit board coated by the method.

## Description

### Technical Field

The present invention relates to a coating machine for electric or electronic circuit boards such as, for example, printed circuit boards on which various electronic parts are provided, a method of coating electric or electronic circuit boards using the machine and an electric or electronic circuit board fabricated by the method.

### Background Art

As a prior process for assembling and bonding electronic parts(chip parts) having, e.g., resistors, capacitors, transistors etc., formed on chips, to a printed circuit board having a circuit pattern of interconnections formed thereon, by soldering, a coating agent, specifically, a photo solder resist, is coated on both the front and rear sides of the printed circuit board.

Generally, there are various application methods for coating a liquid coating material onto electric or electronic circuit boards, including, for example, screen printing, curtain-coating, roll coating, spray coating, rotary atomizing utilizing static electricity, electrodeposition (ED) by electrolyte plating, and the like.

As is well known, each of these various application methods is used in its proper way depending on the purpose, taking into account the surface conditions of the application surface, outside dimensions and shape of a printed circuit board, the workpiece to be coated, the throughput, the production process, the viscosity, type and cost of the coating material, and other factors.

In the conventional application method mentioned above, or in the screen printing process, while ink as a liquid coating material is supplied over a printing plate, the plate is pressurized with a squeegee to form a coating. However, this process needs a certain level of skill and a high technique of application. Further, this method not only needs production and maintenance of a dedicated plate, but also has a drawback of less productivity because coating of a circuit board can only be practically done on one side.

The curtain coating process performs coating by passing a circuit board through a curtain of a liquid coating material freely falling, and is particularly suitable for application of a circuit board having smooth application surfaces. However, since this method needs a large amount of expensive liquid material for coating electronic parts, it gives rise to a cost problem.

In the roll coating method, coating of a circuit board is implemented by transfer application, or by passing it through the nip of two or more rollers which have been supplied beforehand with a liquid coating material, oppose one another and rotate while squeezing the circuit board. This method is particularly suitable for application of a circuit board having smooth application surfaces in the same way as the curtain coating process is, but has a limit for the application to circuit boards having projections and indentations on their surfaces.

Spray coating may be classified, for example, into the air spray type and the airless spray type. Either type has electrostatic coating configurations in which atomized particles are electrostatically charged and a circuit board which is grounded is used. Because of its simplicity in structure, spray coating has been widely used at present and in particular, is effective not only for circuit boards having flat application surfaces but also for circuit boards having projections and indentations on their surfaces.

In the above spray coating method, it is, however, difficult to collect and reclaim the scattered particles of coating material, which have not deposited on the circuit board, and the oversprayed coating material, resulting in poor transfer efficiency. Accordingly, this method has a cost problem as a method of applying a liquid coating material to expensive electronic parts and the like.

To make matters worse, once the scattered coating particles have deposited on the inner wall of the application booth, the deposited particles cure and grow greater, so there is a fear that the cured particles may fall over the circuit board and may be liable to blemish the coated surfaces of the circuit board, also causing a quality problem. Therefore, for countermeasures against mist, the application booth tends to become greater in inner volume, hence the entire system also tends to be greater in scale.

Further, coating of a circuit board is basically performed on either the front or rear side only for each job. When double-sided coating of a circuit board needs to be performed, it is necessary to provide an inverting mechanism, rotating mechanism or U-turn mechanism for circuit boards, in side the machine, or a similar process should be repeated in the subsequent step. That is, this method also has a problem with productivity.

The rotary atomizing system utilizing static electricity is a so-called 'bell type electrostatic coating' and is suitable for coating conductive circuit boards having complex configurations. This system is widely used for coating of automobile parts, etc., for example, as well as being used for coating machines for plate-like circuit boards such as printed circuit boards, for example.

Though this rotary atomizing system can perform double-sided coating of a circuit board inside the machine, a large inner volume for the application space has to be secured in the application booth because it is necessary to provide an inverting mechanism, rotating mechanism or U-turn mechanism for circuit boards, inside the machine, similarly to the spraying system described above. Hence, it is inevitable that the entire machine becomes large.

In the electrodeposition system (ED system), circuit boards are successively conveyed while being immersed through an electrodeposition bath, so as to form coatings on their surfaces. Accordingly, it is possible to create uniform coatings even with complicated configurations, not to mention circuit boards having application surfaces with projections and indentations, hence this system has been widely used. However, the system is large in scale and expensive as a coating machine for plate-like circuit boards such as printed circuit board, giving rise to a production cost problem, its use is hence limited to high added value productions.

In an application process of plate-like circuit boards, when a liquid coating material is applied to printed circuit boards, for example, especially when a photo solder resist is applied onto both sides of the printed circuit boards with circuit interconnection patterns having been formed, it is important to create highly uniform coating surfaces because covering, with the resist ink, over the edges of projections and indentations on the application surfaces may cause problems.

When printed circuit boards are coated on both sides, the current practice is as follows: one side of the printed board is applied with a liquid coating material first, then after its temporary drying the board is inverted so that the other side is applied with the liquid coating material, being followed by temporary drying.

In the conventional application of a liquid coating material to printed circuit boards, since at least two temporary drying operations have to be done, not only is the productivity lowered but also the permissible range of the drying conditions is narrowed compared to the case of the double-side concurrent process, so as to meet quality control requirements because the drying time of the printed circuit board differs between the front side and rear side.

Further, since the coating agents used for electronic parts such as printed circuit boards are expensive, there is a demand for improvement of economy when a coating agent is applied, by enhancing the transfer efficiency of the coating agent to the circuit boards. There is also a demand for improvement in productivity by simplifying the configuration and mechanism of the machine itself and reducing the machine in size and installation space.

The present invention has been devised in view of the above circumstances, it is therefore an object of the present invention to provide a coating machine for electric or electronic circuit boards, which has a simple mechanism and configuration reduced in size and installation space is improved in productivity and economy, as well as providing a coating method using the machine and a circuit board fabricated by the method.

### Disclosure of Invention

In order to solve the above problems, the present invention is configured as follows.

The feature of the present invention resides in a coating machine which handles electric or electronic circuit boards as workpieces to be coated, comprising: a mounting base; an application booth arranged on the mounting base and having an opening at the top thereof to allow a circuit board to be put into, and taken out of, an application space therein; a pair of nozzle units, each having a plurality of spray nozzles arrayed horizontally, disposed on the front and rear inner walls defining the application space in the application booth so that the direction of ejection of each nozzle unit opposes that of the other; a coating agent ejection feeder which, by bifurcating, supplies the pressurized coating agent to branch manifolds, each connected to the spray nozzles of the associated nozzle unit; and a circuit board conveyer and controller which suspends the circuit board at a hanger structure in a detachable manner and conveys it in the vertical direction into, and out of, the application space in the application booth between the opposing nozzle units, where the coating agent fed from the coating agent ejection feeder is ejected from the individual spray nozzles toward the front and rear application surfaces of the circuit board, the coating machine being characterized in that the circuit board conveyer and controller suspends the circuit board so that its front and rear surfaces to be coated oppose the respective nozzle units and performs control so that the circuit board is conveyed into and out of the application booth through the top opening thereof and is moved vertically in the conveying direction perpendicular to the direction in which spray nozzles are arrayed; and an exhaust portion in communication with the lower part of the application space is provided in the application booth.

In the present invention, when the nozzle units are arranged so as to oppose each other with their directions of ejection inclined downwards with respect to the horizontal direction, it is possible to cause air inside the application space to circulate, whereby a more uniform application can be achieved. In particular, it is preferred that the directions of ejection from the nozzle units are inclined downwards from the horizontal direction, at an angle within the range of 15° to 45°.

In the present invention, each of the above nozzle units has a width in which two or more spray nozzles are arrayed while the areas of the coating agent sprayed from individual spray nozzles form a continuous range, at least, covering the width of the application surface of the circuit board.

In the present invention, the application space in the application booth may have a minimum inner volume that approximates the maximum outside dimensions of the circuit board and is just large enough to provide the function of correct application.

In the present invention, a coating agent collector capable of collecting the coating agent which is discharged out of the application space in the application booth through a drainage port may be provided.

The present invention may be an application method for electric or electronic circuit boards using the above coating machine, comprising the steps of: suspending an electric or electronic circuit board and positioning and conveying it between a pair of nozzle units arranged opposing each other in the application space inside the application booth; and spray coating the front and rear application surfaces of the circuit board with a coating agent ejected from the plurality of spray nozzles arrayed on the nozzle units whilst the circuit board is being moved vertically in a direction perpendicular to the direction in which the individual spray nozzles are arrayed.

In the present invention, the individual spray nozzles can be arranged horizontally in a row at regular intervals across the width of each nozzle unit while the circuit board can be moved in a reciprocating manner in the vertical direction.

Further, the present invention may be an electric or electronic circuit board fabricated by an application method for electric or electronic circuit boards using the above coating machine, comprising the steps of: suspending an electric or electronic circuit board and positioning and conveying it between a pair of nozzle units arranged opposing each other in the application space inside the application booth; and spray coating the front and rear application surfaces of the circuit board with a coating agent ejected from the plurality of spray nozzles arrayed on the nozzle units whilst the circuit board is being moved vertically in a direction perpendicular to the direction in which the individual spray nozzles are arrayed.

Illustratively, in the present invention, based on use of the above configuration, an electric or electronic circuit board as a workpiece to be coated, is suspended, positioned and conveyed between a pair of nozzle units arranged opposing each other in the application space in the application booth, and a coating agent is sprayed from the plurality of spray nozzles arrayed horizontally in a row, for example, on the nozzle units and applied onto both the front and rear application surfaces of the circuit board while the circuit board is moved vertically in a direction perpendicular to the direction in which the spray nozzles are arranged. As a result, it is possible to easily implement an application work by use of a spray coating method, without the necessity of a skillful, manipulative techniques. Further, this configuration can implement application of the coating agent over both the front and rear application surfaces of a circuit board at the same time, without the necessity of providing an inverting mechanism, rotational mechanism, U-turn mechanism or the like for circuit boards, inside the machine, as used to be needed conventionally. Thus, this configuration makes it possible to promote reduction of the whole machine in size.

Moreover, since the exhaust portion connected to the lower part of the application space in the application booth is provided, its suctioning function prevents particles of coating agent scattering out from the opening at the top of the application booth, through which workpieces to be coated are put in and taken out. As a result, it is possible to prevent ambient pollution with the coating agent as well as to lower the atmospheric concentration of the solvent inside the application booth.

Further, for example, each nozzle unit has a width in which two or more spray nozzles can be arrayed while the areas of the coating agent sprayed from individual spray nozzles form a continuous range, at least, covering the width of the application surface of the electric or electronic circuit board. Further, when the application space in the application booth is adapted to have a minimum inner volume that approximates the maximum outside dimensions of the circuit board and is just large enough to provide the function of correct application, it is possible to reduce the inner volume of the application booth. Accordingly, there is no need to provide an inverting mechanism, rotational mechanism, U-turn mechanism or the like for the circuit board, inside the machine, as used to be needed conventionally, hence it is possible to make the whole machine compact and reduce the space for its installation.

Still more, when the coating agent collector capable of collecting the coating agent which is discharged out of the application space in the application booth, through the drainage port is provided, it is possible to reuse the coating agent hence enhance the transfer efficiency of the coating agent to circuit boards.

### Brief Description of Drawings

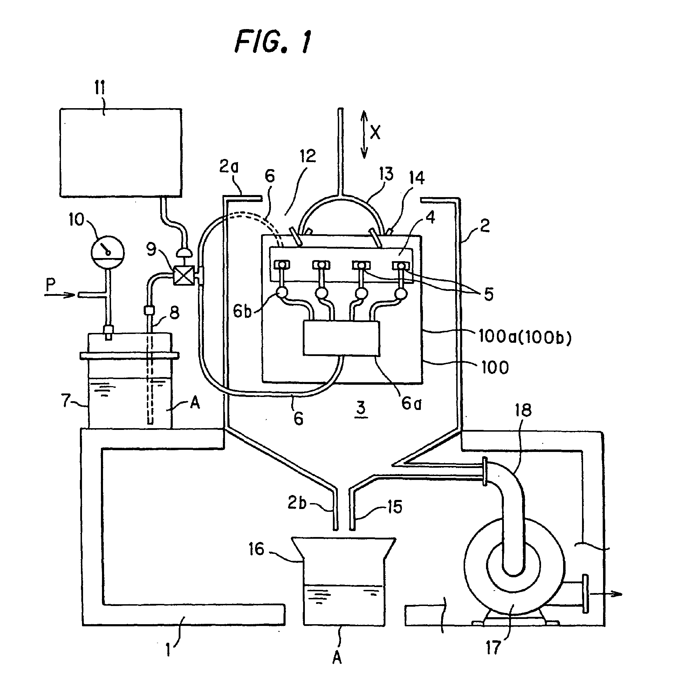

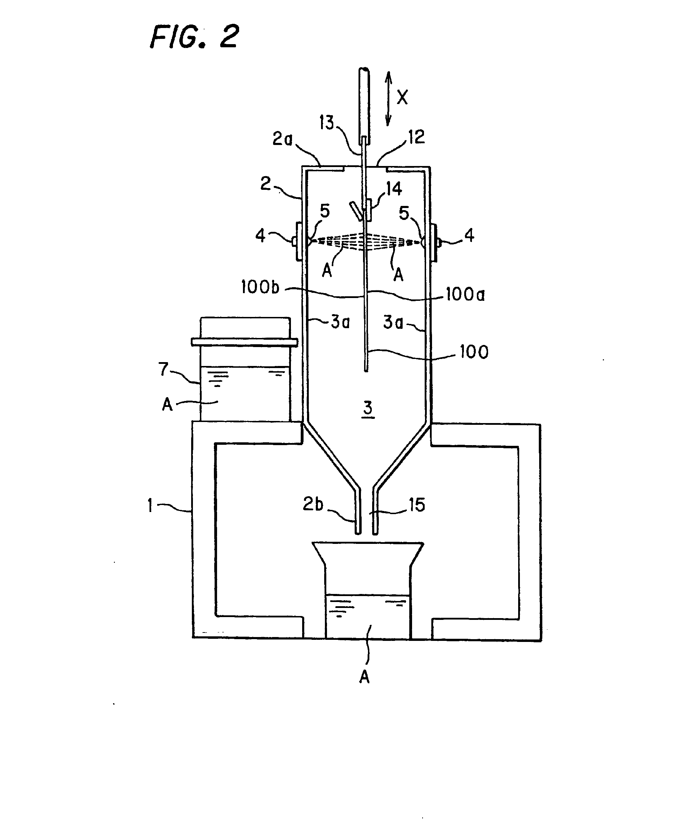

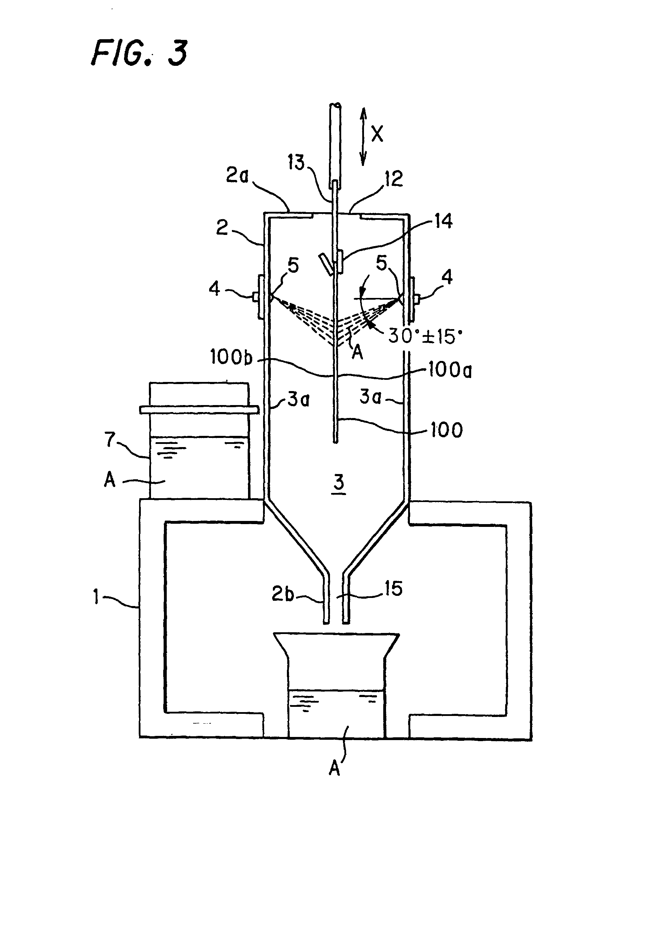

Fig.1 is a schematic illustrative view showing an embodiment of a coating machine of the present invention; Fig.2 is a schematic sectional view of the same configuration; and Fig.3 is a schematic illustrative view showing another embodiment of a coating machine of the present invention.

### Best Mode for Carrying Out the Invention

The embodiments of the present invention will be described hereinbelow with reference to the drawings.

Figs. 1 and 2 schematically show the overall configuration of an embodiment of a coating machine in accordance with the present invention. A reference numeral 1 designates a mounting base. 2 an application booth, set on the mounting base 1, 3 an application space in the application booth 2, 4, 4 a pair of nozzle units arranged opposing each other, on front and rear inner walls 3a, 3a of application space 3.

Application space 3 in application booth 2 has a rectangular box-like form which has a minimum inner volume that approximates the maximum outside dimensions of a printed circuit board 100 as an object to be coated and is just large enough to provide the function of correct application.

Each nozzle unit 4 is configured of two or more (four, in the illustrated embodiment) spray nozzles 5, such as two fluid nozzles, airless nozzles, or the like, arranged horizontally in a row at regular intervals across the width of 500 mm, for example.

Spray nozzles 5, each ejecting a coating agent, namely a liquid coating material A such as a photo solder resist, for example, to be applied to front and rear application surfaces 100a and 100b on both sides of printed circuit board 100 after circuit interconnection patterns are formed thereon, are arranged so that individual spraying areas form a continuous range, at least, covering the width of the application surface of printed circuit board 100.

Spray nozzles 5 of nozzle units 4 are connected to conveying tubes 6, which in turn are connected to a pressurized tank 7 storing liquid coating material A, via a conveying pipe 8 and an air operation valve 9 with appropriate branches. More specifically, conveying tube 6 originated from operation valve 9 is connected to a branch manifold 6a, which in turn branches the flow into a plurality of tubes, each being connected to an individual spray nozzle 5. Each branch tube has a regulator 6b, so as to eject a fixed amount of the liquid coating material from each spray nozzle 5.

The directions of ejection from spray nozzles 5 are set horizontal. Accordingly, in reality the liquid coating material discharged from spray nozzles 5 is applied onto the front and rear application surfaces 100a and 100b of printed circuit board 100, within a predetermined range distributed with respect to the horizontal axis as the center. Thus, setting the directions of ejection from spray nozzles 5 to be horizontal and opposite sides to each other, makes it possible to shorten the distance from spray nozzles 5 to printed circuit board 100, leading to achievement of coating with an efficient amount of liquid coating material.

Pressurized tank 7 is configured so that a compressed gas P of air, nitrogen gas or the like, is held therein under pressure and the pressurized state is monitored by a pressure gauge 10. When air operation valve 9 is released by operating a control board (control panel) 11, liquid coating material A is adapted to eject from individual spray nozzles 5 of nozzle units 4 opposing each other. The thus arranged conveying tubes 6, pressurized tank 7, conveying pipe 8, air operation valve 9, pressure gauge 10 and control board (control panel) 11 constitute a coating agent ejection feeder.

Though, in this embodiment, the liquid coating material is stored with a compressed gas P in pressurized tank 7 so as to be conveyed by pressure, any other configuration such as a pressurized unit having a pressure-feed pump may be used instead of a pressurized tank as long as it can convey the liquid coating material to the nozzle units.

Formed on the top 2a of application booth 2 is an opening 12 having a width corresponding to the maximum outer size of printed circuit board 100 so as to allow printed circuit board 100 to be put in and taken out.

Illustratively, printed circuit board 100 is detachably fixed to a hanger structure 13 as a part of a workpiece conveyer and controller by a clamp 14 and is suspended thereby and controlled so as to be conveyed in a reciprocating manner in the vertical direction, designated by X, perpendicular to the direction in which spray nozzles 5 are arranged. When a coating process is implemented, the printed circuit board is fed into application space 3 through opening 12 formed on the top surface of application booth 2 and positioned to be approximately equi-distant from nozzle units 4 and 4 opposing each other in application space 3, so that both front and rear coating sides 100a and 100b face spray nozzles 5 of opposing nozzle units 4, 4.

In this case, printed circuit board 100 is positioned with its upper or lower edge aligned with the arrays of spray nozzles 5 on nozzle units 4 and 4, and after the positioning, the printed circuit board 100 is moved down or up while liquid coating material A is ejected from all spray nozzles 5 on nozzle units 4 and 4 in time with the vertical movement, whereby both the front and rear application surfaces 100a and 100b of printed circuit board 100 are spray coated simultaneously.

Arranged in the lower part 2b of application booth 2 is a drainage port 15 of a hopper configuration. A collecting tank 16 is arranged on mounting base 1 at a lower position corresponding to the drainage port 15. This collecting tank 16 collects and holds surplus liquid coating material A which has been sprayed in application space 3 inside application booth 2 and drained externally through drainage port 15, whereby it is possible to reuse surplus liquid coating material A after the application process.

Application booth 2 further has an exhaust duct 18 connected to exhaust blower 17 and arranged in communication with the lower part of application space 3, so that ink particles of liquid coating material A which would scatter out of opening 12 of application booth 2 can be suctioned by the suctioning function of exhaust blower 17. This exhaust function also lowers the atmospheric concentration of the solvent in application space 3 during the coating process.

It should be noted the present invention is not limited to the above embodiments and it is not to mention that many changes can be made without departing from the spirit and scope of the invention.

For example, in the above embodiment, the directions of ejection from spray nozzles 5 are set approximately horizontal (perpendicular to the application surfaces), however the direction should not be limited to this. That is, as shown in Fig.3, the directions of ejection from spray nozzles 5 may be inclined at a certain angle with respect to the front and rear application surfaces 100a and 100b of printed circuit board 100. By arranging spray nozzles 5 opposing each other with their directions of ejection angled with respect to the horizontal direction, air inside application space 3 could be caused to circulate, whereby uniform application could be achieved. More specifically, when spray nozzles 5 were arranged opposing each other with their directions of ejection inclined at an angle of 30° ±15° with respect to the horizontal direction, or at angle from 15° to 45° with respect to the horizontal direction, circulation of air inside application space 3 could be improved so that more beneficial application result could be obtained.

As understood from the explanation heretofore, according to the present invention, an electric or electronic circuit board as a workpiece to be coated, is suspended, positioned and conveyed between a pair of nozzle units arranged opposing each other in the application space in the application booth, and a coating agent is ejected from the plurality of spray nozzles arrayed horizontally on the nozzle units and applied onto both the front and rear application surfaces of the circuit board while the plate-like workpiece to be coated is moved vertically in a direction perpendicular to the direction in which the spray nozzles are arranged. As a result, it is possible to easily implement an application process by use of a spray coating method, without the necessity of skillful, manipulative techniques. Further, this configuration, using a simple mechanism and structure, can implement application of the coating agent over both the front and rear application surfaces of a circuit board at one time, without the necessity of providing an inverting mechanism, rotational mechanism, U-turn mechanism or the like for circuit boards, inside the machine, as used to be needed conventionally. Thus, this configuration makes it possible to improve the productivity and promote reduction of the whole machine in size.

In the present invention, when the nozzle units, opposing each other, are adjusted so that the directions of ejection from the nozzle units are inclined downwards with respect to the approximate horizontal direction, it is possible to cause air inside the application space to circulate, whereby a more uniform application can be achieved. In particular, it is preferred that the directions of ejection from the nozzle units are inclined downwards from the horizontal direction, at an angle within the range of 15° to 45°.

Further, each nozzle unit has a width in which two or more spray nozzles are arrayed while the areas of the coating agent sprayed from individual spray nozzles form a continuous range, at least, covering the width of the application surface of the printed circuit board. Further, since the application space in the application booth is adapted to have a minimum inner volume that approximates the maximum outside dimensions of the circuit board and is just large enough to provide the function of correct application, it is possible to reduce the inner volume of the application booth. Accordingly, there is no need to provide an inverting mechanism, rotational mechanism, U-turn mechanism or the like for circuit boards, inside the machine, as used to be needed conventionally, hence it is possible to make the whole machine compact and reduce the space for its installation.

Further, since the coating agent collector for collecting the coating agent which is discharged out of the application space in the application booth through the drainage port is provided, it is possible to reuse the coating agent. As a result, it is possible to enhance the transfer efficiency of the coating agent to circuit boards with improved economy.

Moreover, since the exhaust portion connected to the lower part of the application space in the application booth is provided, its suctioning function prevents particles of coating agent from scattering out from the opening at the top of the application booth, through which circuit boards are put in and taken out. As a result, it is possible to prevent ambient pollution with the coating agent as well as to lower the atmospheric concentration of the solvent inside the application booth.

### Industrial Applicability

Thus, the configuration described heretofore is suitable for a coating machine using a spray coating system and makes it possible to implement application of a coating agent over both the front and rear application surfaces of a circuit board simultaneously, hence improving productivity and reducing the whole machine in size.

## Claims

1. A coating machine which handles electric or electronic circuit boards as workpieces to be coated, comprising:
a mounting base;
an application booth arranged on the mounting base and having an opening at the top thereof to allow a circuit board to be put into, and taken out of, an application space therein;
a pair of nozzle units, each having a plurality of spray nozzles arrayed horizontally, disposed on the front and rear inner walls defining the application space in the application booth so that the direction of ejection of each nozzle unit opposes that of the other;
a coating agent ejection feeder which, by bifurcating, supplies the pressurized coating agent to branch manifolds, each connected to the spray nozzles of the associated nozzle unit; and
a circuit board conveyer and controller which suspends the circuit board at a hanger structure in a detachable manner and conveys it in the vertical direction into, and out of, the application space in the application booth between the opposing nozzle units, where the coating agent fed from the coating agent ejection feeder is ejected from the individual spray nozzles toward the front and rear application surfaces of the circuit board,
wherein the circuit board conveyer and controller suspends the circuit board so that its front and rear surfaces to be coated oppose the respective nozzle units and performs control so that the circuit board is conveyed into and out of the application booth through the top opening thereof and is moved vertically in the conveying direction perpendicular to the direction in which spray nozzles are arrayed; and an exhaust portion in communication with the lower part of the application space is provided in the application booth.

2. The coating machine for electric or electronic circuit boards according to Claim 1, wherein the nozzle units are arranged so as to oppose each other with their directions of ejection inclined downwards with respect to the horizontal direction.

3. The coating machine for electric or electronic circuit boards according to Claim 2, wherein the directions of ejection from the nozzle unit are set downwards at an angle within the range of 15° to 45° with respect to the horizontal direction.

4. The coating machine for electric or electronic circuit boards according to Claim 1, wherein the nozzle unit has a width in which two or more spray nozzles are arrayed and the areas of the coating agent sprayed from individual spray nozzles form a continuous range, at least, covering the width of the application surface of the circuit board.

5. The coating machine for electric or electronic circuit boards according to Claim 1, wherein the application space in the application booth has a minimum inner volume that approximates the maximum outside dimensions of the circuit board and is just large enough to provide the function of correct application.

6. The coating machine for electric or electronic circuit boards according to Claim 1, further comprising:
a coating agent collector capable of collecting the coating agent which is discharged out of the application space in the application booth through a drainage port.

7. The coating machine for electric or electronic circuit boards according to Claim 3, further comprising:
a coating agent collector capable of collecting the coating agent which is discharged out of the application space in the application booth through a drainage port.

8. An application method for electric or electronic circuit boards using one of the coating machines defined in Claims 1 through 7, comprising the steps of:
suspending an electric or electronic circuit board and positioning and conveying it between a pair of nozzle units arranged opposing each other in the application space inside the application booth; and
spray coating the front and rear application surfaces of the circuit board with a coating agent ejected from the plurality of spray nozzles arrayed on the nozzle units while the circuit board is being moved vertically in a direction perpendicular to the direction in which the individual spray nozzles are arrayed.

9. The application method for electric or electronic circuit boards according to Claim 8, wherein the individual spray nozzles of each nozzle unit are arranged horizontally in a row at regular intervals while the circuit board is moved in the vertical direction, in a reciprocating manner.

10. An electric or electronic circuit board coated by the application method for electric or electronic circuit boards according to Claim 8.
